# EUROPEAN PATENT APPLICATION

(11) **EP 2 562 291 A1**
(43) Date of publication of application: **27.02.2013**
(21) Application number: 12193898.9
(22) Date of filing: 28.08.2009
(51) Int. Cl.: C23C 16/458, H01L 21/687

(54) **Wafer carrier with varying thermal resistance**

(30) Priority: 29.08.2008 US 190494 P
(62) Divisional of application: 09810392.2
(71) Applicant: Veeco Instruments Inc., Plainview, NY 11803 (US)
(72) Inventor: Volf, Boris, Hillsborough, NJ New Jersey 08844 (US); Soderman, Breid, Doylestown, PA Pennsylvania 18902 (US); Armour, Eric, A., Pennington, NJ New Jersey 08534 (US)
(74) Representative: Garratt, Peter Douglas

(57) **Abstract**

In chemical vapor deposition apparatus, a wafer carrier (32) has a top surface (34) holding the wafers and a bottom surface (36) heated by radiant heat transfer from a heating element (28). The bottom surface (36) of the wafer carrier is non-planar due to features such as depressions (54) so that the wafer carrier has different thickness at different locations. The thicker portions of the wafer carrier have higher thermal resistance. Differences in thermal resistance at different locations counteract undesired non-uniformities in heat transfer to the wafer. The wafer carrier may have pockets with projections (553, 853) for engaging spaced-apart locations on the edges of the wafer.

## Description

### CROSS-REFERENCE TO RELATED APPLICATIONS

The present application claims the benefit of the filing date of U.S. Provisional Patent Application No. 61/190,494, filed August 29, 2008, the disclosure of which is hereby incorporated by reference herein.

### BACKGROUND OF THE INVENTION

The present invention relates to wafer processing apparatus, to wafer carriers for use in such processing apparatus, and to methods of wafer processing.

Many semiconductor devices are formed by epitaxial growth of a semiconductor material on a substrate. The substrate typically is a crystalline material in the form of a disc, commonly referred to as a "wafer." For example, devices formed from compound semiconductors such as III-V semiconductors typically are formed by growing successive layers of the compound semiconductor using metal organic chemical vapor deposition or "MOCVD." In this process, the wafers are exposed to a combination of gases, typically including a metal organic compound and a source of a group V element which flow over the surface of the wafer while the wafer is maintained at an elevated temperature. One example of a III-V semiconductor is gallium nitride, which can be formed by reaction of an organo gallium compound and ammonia on a substrate having a suitable crystal lattice spacing, as for example, a sapphire wafer. Typically, the wafer is maintained at a temperature on the order of 500-1100°C during deposition of gallium nitride and related compounds.

Composite devices can be fabricated by depositing numerous layers in succession on the surface of the wafer under slightly different reaction conditions, as for example, additions of other group III or group V elements to vary the crystal structure and bandgap of the semiconductor. For example, in a gallium nitride based semiconductor, indium, aluminum or both can be used in varying proportion to vary the bandgap of the semiconductor. Also, p-type or n-type dopants can be added to control the conductivity of each layer. After all of the semiconductor layers have been formed and, typically, after appropriate electric contacts have been applied, the wafer is cut into individual devices. Devices such as light-emitting diodes ("LEDs"), lasers, and other electronic and optoelectronic devices can be fabricated in this way.

In a typical chemical vapor deposition process, numerous wafers are held on a device commonly referred to as a wafer carrier so that a top surface of each wafer is exposed at the top surface of the wafer carrier. The wafer carrier is then placed into a reaction chamber and maintained at the desired temperature while the gas mixture flows over the surface of the wafer carrier. It is important to maintain uniform conditions at all points on the top surfaces of the various wafers on the carrier during the process. Minor variations in composition of the reactive gases and in the temperature of the wafer surfaces cause undesired variations in the properties of the resulting semiconductor device. For example, if a gallium and indium nitride layer is deposited, variations in wafer surface temperature will cause variations in the composition and bandgap of the deposited layer. Because indium has a relatively high vapor pressure, the deposited layer will have a lower proportion of indium and a greater bandgap in those regions of the wafer where the surface temperature is higher. If the deposited layer is an active, light-emitting layer of an LED structure, the emission wavelength of the LEDs formed from the wafer will also vary. Thus, considerable effort has been devoted in the art heretofore towards maintaining uniform conditions.

One type of CVD apparatus which has been widely accepted in the industry uses a wafer carrier in the form of a large disc with numerous wafer-holding regions, each adapted to hold one wafer. The wafer carrier is supported on a spindle within the reaction chamber so that the top surface of the wafer carrier having the exposed surfaces of the wafers faces upwardly toward a gas distribution element. While the spindle is rotated, the gas is directed downwardly onto the top surface of the wafer carrier and flows across the top surface toward the periphery of the wafer carrier. The used gas is evacuated from the reaction chamber through ports disposed below the wafer carrier. The wafer carrier is maintained at the desired elevated temperature by heating elements, typically electrical resistive heating elements disposed below the bottom surface of the wafer carrier. These heating elements are maintained at a temperature above the desired temperature of the wafer surfaces, whereas the gas distribution element typically is maintained at a temperature well below the desired reaction temperature so as to prevent premature reaction of the gases. Therefore, heat is transferred from the resistive heating element to the bottom surface of the wafer carrier and flows upwardly through the wafer carrier to the individual wafers.

Although considerable effort has been devoted in the art heretofore to design an optimization of such systems, still further improvement would be desirable. In particular, it would be desirable to provide better uniformity of temperature across the surface of each wafer, and better temperature uniformity across the entire wafer carrier.

### BRIEF SUMMARY OF THE INVENTION

One aspect of the invention provides chemical vapor deposition apparatus. Apparatus according to this aspect of the invention desirably includes a reaction chamber, a gas inlet structure communicating with the reaction chamber, and a heating element mounted within the reaction chamber. The apparatus according to this aspect of the invention desirably also includes a wafer carrier comprising a body having oppositely-facing top and bottom surfaces. The wafer carrier preferably is mounted in the reaction chamber so that heat evolved in the heating element will be transferred principally by radiant heat transfer from the heating element to the bottom surface of the wafer carrier. For example, the wafer carrier may be mounted above the heating element with the bottom surface of the body directly confronting the heating element. The body of the wafer carrier desirably has a plurality of wafer-holding regions and a wafer support in each wafer-holding region. Each wafer support is adapted to hold a wafer with a top surface of the wafer exposed at the top surface of the body. Most preferably, the bottom surface of the body is non-planar so that the body varies in thickness. As further explained below, the differences in thickness cause differences in resistance to heat conduction in the vertical direction through the wafer carrier. Desirably, an aggregate thermal resistance between the heating element and an arbitrary location on the top surface of the wafer carrier varies directly with the thickness of the body at that location.

As further discussed below, these differences in thermal resistance can be used to compensate for factors such as bowing of the wafers which cause non-uniformity in heat transfer between the wafer carrier and the wafer. The non-planar bottom surface and related difference in thermal resistance can also be used to counteract other causes of non-uniform temperature distribution in the wafers and in the top surface of the wafer carrier.

A further aspect of the invention provides methods of processing wafers. A method according to this aspect of the invention desirably includes the steps of mounting one or more wafers on a wafer carrier so that each wafer is disposed within a wafer-holding region of the carrier and exposed at a top surface of the carrier, the carrier having varying thermal conductance within each wafer-holding region. The method desirably also includes the step of heating a bottom surface of the wafer carrier so that heat transmitted through the wafer carrier maintains the wafers at an elevated temperature. While the wafers are at the elevated temperature, reactive gasses may be applied to affect the exposed surfaces of the wafers as, for example, by forming a deposit on the exposed surfaces. In the method according to this aspect of the invention, the wafers may be bowed during the step of applying reactive gasses. The bowing causes non-uniformity in heat transfer from the wafer carrier to the wafer within each wafer. Most preferably, the varying thermal conductance of the wafer carrier at least partially compensates for the non-uniformity in heat transfer caused by the bowing.

Yet another aspect of the invention provides a wafer carrier. A wafer carrier according to this aspect of the invention desirably includes a body having oppositely-facing top and bottom surfaces and a central axis extending between the top and bottom surfaces. The top surface of the body typically has a plurality of pockets, each such pocket having a peripheral wall. The peripheral wall of each pocket most preferably has a plurality of spaced-apart projections in a region of the peripheral wall remote from the central axis of the wafer carrier, the projections being adapted to engage spaced-apart portions of an edge of a wafer disposed in the pocket. As further explained below, such projections help to minimize contact between the edge of the wafer and the peripheral wall, and help to hold the wafer centered in the pocket. These effects in turn tend to promote better temperature uniformity across the top surface of each wafer.

These and other features and advantages will be more readily apparent from the detailed description set forth below, taken in conjunction with the drawings.

### BRIEF DESCRIPTION OF THE DRAWINGS

FIG. 1 is a simplified, schematic sectional view depicting chemical vapor deposition apparatus in accordance with one embodiment of the invention.

FIG. 2 is a diagrammatic top plan view of a wafer carrier used in the apparatus of FIG. 1.

FIG. 3 is a fragmentary, diagrammatic sectional view taken along line 3-3 in FIG. 2, depicting the wafer carrier in conjunction with a wafer.

FIGS. 4-7 are views similar to FIG. 3 but depicting wafer carriers according to further embodiments of the invention.

FIG. 8 is fragmentary, diagrammatic top plan view depicting a portion of a wafer carrier in accordance with yet another embodiment of the invention.

FIG. 9 is a fragmentary sectional view taken along line 9-9 in FIG. 8.

FIGS. 10, 11 and 12 are fragmentary, diagrammatic sectional views depicting wafer carriers according to additional embodiments of the invention.

FIG. 13 is a fragmentary, diagrammatic top plan view of the wafer carrier shown in FIG. 12.

FIG. 14 is a fragmentary, diagrammatic top plan view on an enlarged scale, depicting the area indicated in FIG. 13.

FIG. 15 is a fragmentary, diagrammatic sectional views depicting a wafer carriers according to a still further embodiment of the invention.

### DETAILED DESCRIPTION

Chemical vapor deposition apparatus in accordance with one embodiment of the invention includes a reaction chamber 10 having a gas distribution element 12 arranged at one end of the chamber. The end having the gas distribution element 12 is referred to herein as the "top" end of the chamber 10. This end of the chamber typically, but not necessarily, is disposed at the top of the chamber in the normal gravitational frame of reference. Thus, the downward direction as used herein refers to the direction away from the gas distribution element 12; whereas the upward direction refers to the direction within the chamber, toward the gas distribution element 12, regardless of whether these directions are aligned with the gravitational upward and downward directions. Similarly, the "top" and "bottom" surfaces of elements are described herein with reference to the frame of reference of chamber 10 and element 12. Gas distribution element 12 is connected to sources 14 of gases to be used in the CVD process, such as a carrier gas and reactant gases such as a source of a group III metal, typically a metalorganic compound, and a source of a group V element as, for example, ammonia or other group V hydride. The gas distribution element is arranged to receive the various gases and direct a flow of gasses generally in the downward direction. The gas distribution element 12 desirably is also connected to a coolant system 16 arranged to circulate a liquid through the gas distribution element so as to maintain the temperature of the element at a desired temperature during operation. Chamber 10 is also.equipped with an exhaust system 18 arranged to remove spent gases from the interior of the chamber through ports (not shown) at or near the bottom of the chamber so as to permit continuous flow of gas in the downward direction from the gas distribution element.

A spindle 20 is arranged within the chamber so that the central axis 22 of the spindle extends in the upward and downward directions. The spindle has a fitting 24 at its top end, i.e., at the end of the spindle closest to the gas distribution element 12. In the particular embodiment depicted, the fitting 24 is a generally conical element. Spindle 20 is connected to a rotary drive mechanism 26 such as an electric motor drive, which is arranged to rotate the spindle about axis 22. A heating element 28 is mounted within the chamber and surrounds spindle 20 below fitting 24. The chamber is also provided with an openable port 30 for insertion and removal of wafer carriers. The foregoing elements may be of conventional construction. For example, suitable reaction chambers are sold commercially under the registered trademark TURBODISC by the Veeco Instruments, Inc. of Plainview, New York, USA, assignee of the present application.

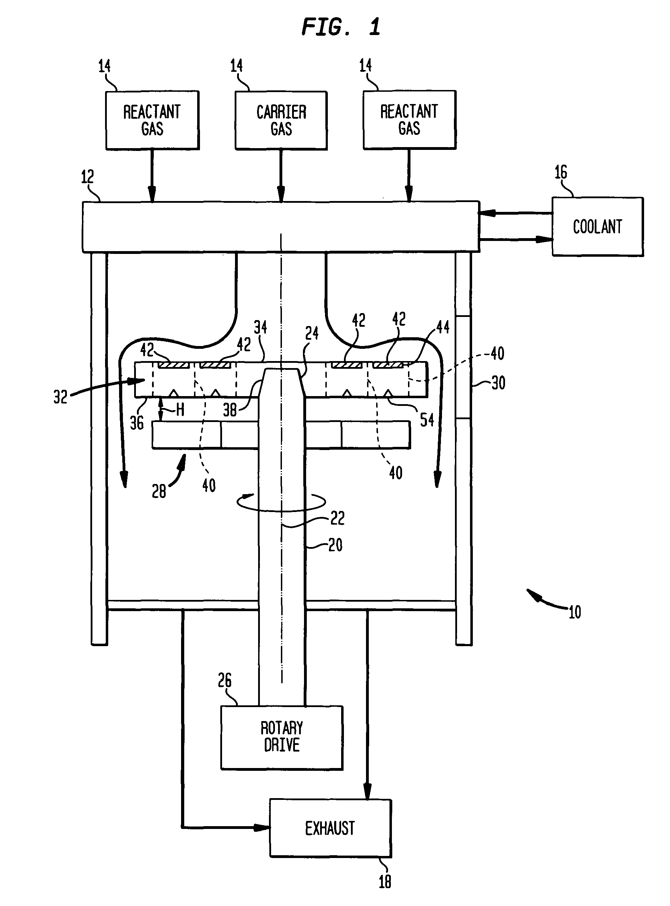

In the operative condition depicted in FIG. 1, a wafer carrier 32 is mounted on the fitting 24 of the spindle. The wafer carrier has a structure which includes a body generally in the form of a circular disc. The body desirably is formed as a monolithic slab of a non-metallic refractory material as, for example, a material selected from the group consisting of silicon carbide, boron nitride, boron carbide, aluminum nitride, alumina, sapphire, quartz, graphite, and combinations thereof, with or without a refractory coating as, for example, a carbide, nitride or oxide. The body of the wafer carrier has a first major surface, referred to herein as the "top" surface 34, and a second major surface, referred to herein as the "bottom" surface 36. The structure of the wafer carrier also has a fitting 38 arranged to engage the fitting 24 of the spindle and to hold the body of the wafer carrier on the spindle with the top surface 34 facing upwardly toward the gas distribution element 12, and with the bottom surface 36 facing downwardly toward heating element 28 and away from the gas distribution element. Merely by way of example, the wafer carrier body may be about 465 mm in diameter, and the thickness of the carrier between top surface 34 and bottom surface 32 may be on the order of 15.9 mm. In the particular embodiment illustrated, the fitting 38 is formed as a frustoconical depression in the bottom surface of the body 32. However, as described in copending, commonly assigned U.S. Patent Publication No. 2009-0155028 A1, the disclosure of which is hereby incorporated by reference herein, the structure may include a hub formed separately from the body and the fitting may be incorporated in such a hub. Also, the configuration of the fitting will depend on the configuration of the spindle.

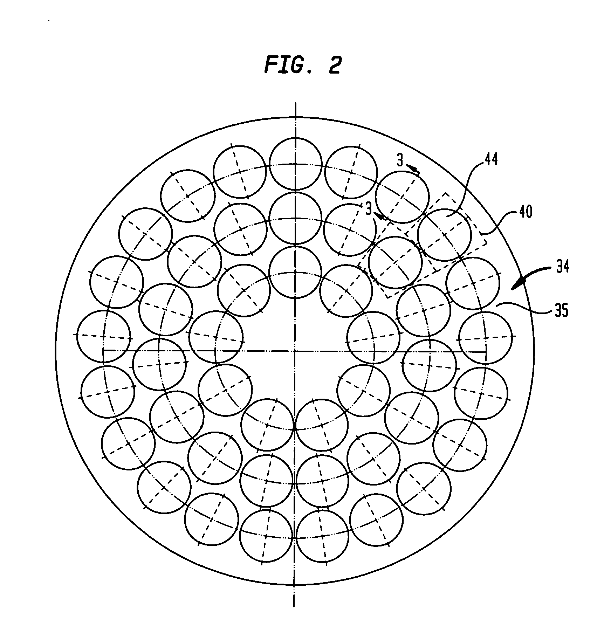

Wafer carrier 32 has numerous individual wafer-holding regions 40 denoted by broken lines in FIGS. 1-3. Although the wafer-holding regions are demarcated by broken lines in FIGS. 1-3 for clarity of illustration, there typically is no discernable physical boundary between adjacent wafer holding regions. The top surface 34 of the wafer carrier includes a continuous main portion 35 extending into the various wafer-holding regions. Main portion 35 may be generally planar. Each wafer-holding region includes a wafer support adapted to hold an individual wafer 42. In the particular embodiment depicted in FIGS. 1-3, the wafer support in each wafer-holding region includes a circular pocket 44 extending into the body of the wafer carrier from the main portion 35 of top surface 34, each such pocket having a floor surface 46 recessed below the general level of top surface 34 defined by the main portion 35. In this embodiment, floor surface 46 is nominally a flat surface, and ideally would be exactly flat. However, practical manufacturing tolerances typically limit its flatness to about 0.0005 inches (13 µm) maximum deviation from a perfectly flat plane, with any such deviation being such as to make the floor surface concave. As used in this disclosure, the term "substantially flat" should be understood as referring to a surface which is flat to within about 30 µm or less. Floor surface 46 is in the form of a circle having a central axis 48 substantially perpendicular to the general plane of top surface 34. A support ledge 50 surrounds floor surface 46, the support ledge 50 having an upwardly facing surface which is elevated slightly above floor surface 46. The support ledge 50 is in the form of a loop encircling the floor surface and concentric with the central axis 48. In the embodiment shown, each pocket is arranged to receive a wafer about 2 inches (50.8 mm) in diameter. For a nominal 2-inch (5cm) wafer diameter, the upwardly facing surface of support ledge 50 is at a distance D₄₆ on the order of about 20 µm to about 100 µm, and desirably about 20-50 µm above floor surface 46 and the width W₅₀ of the ledge may be about 0.5-0.7 mm. For larger pockets intended to hold larger wafers, these dimensions typically would be greater. The surface of the support ledge 50 desirably is disposed in a plane parallel to the plane of floor surface 46. Support ledge 50 is also recessed below the main portion 35 of the wafer carrier top surface 34. Desirably, the distance D₅₀ from the top surface 34 to the upwardly facing surface of the support ledge is about 75-175 µm more than the thickness of a wafer to be processed. For example, in a wafer carrier arranged to process sapphire wafers of 2 inch nominal diameter and 430 nm nominal thickness, D₅₀ may be about 500-600 µm.

A wall 52 extends upwardly from the support ledge 50 to the top surface 34 of the wafer carrier around the entire periphery of the support ledge, and hence around the entire periphery of pocket 44. Wall 52 is inclined inwardly toward the central axis 48 at an angle A, typically about 10 degrees. Thus, wall 52 is in the form of a frustum of a cone.

The bottom surface 36 of the wafer carrier body 32 is generally planar, except that within each wafer-holding region 40, the bottom surface has a nonplanarity which, in this embodiment, is a generally conical depression 54 extending into the wafer carrier body 32 from the bottom surface. In this embodiment, each depression has an included angle α of about 120° and is on the order of 3-6 mm deep, more typically about 4-5 mm deep. The depression 54 in each wafer-holding region 40 is coaxial with the central axis 48 of the floor surface 46 in that region, so that the depression 54 is aligned with the center of the floor surface. Thus, the thickness t of the wafer carrier body 32 varies within the region aligned with floor 46. The thickness is at a minimum tₘᵢₙ at the center of the floor, at axis 48, and increases progressively to a maximum tₘₐₓ outside of depression 54, near the periphery of the floor. As mentioned above, the wafer carrier body 32 desirably is a monolithic element of substantially uniform composition. Thus, the material constituting the wafer carrier body has substantially uniform thermal conductivity. The thermal conductance of the wafer carrier body in the vertical direction is inversely proportional to the thickness of the wafer carrier body at any location. The thermal resistivity of the wafer carrier body with respect to heat flowing in the vertical direction varies directly with the thickness t of the wafer carrier body. Thus, at the central axis, the thermal resistivity is relatively low; whereas, at the periphery of the floor surface, the thermal resistivity of the wafer carrier body is relatively high.

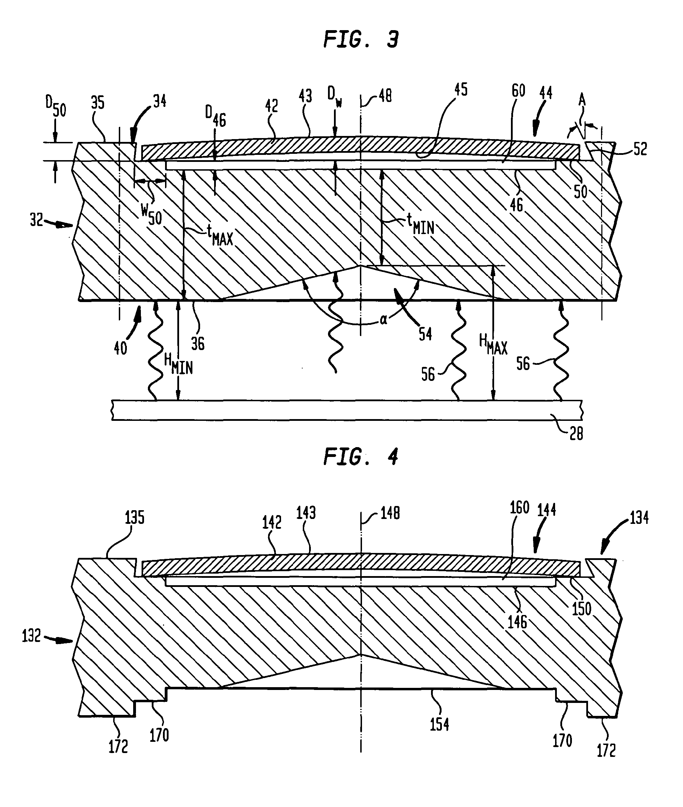

In operation, the wafer carrier is loaded with wafers 42 and placed on the spindle 20 (FIG. 1 ) in the operative position shown. As best seen in FIG. 3, the periphery of each wafer 42 rests on the support ledge 50. Preferably, the overlap between the wafer and the support ledge is at a minimum, as for example, about 1 mm or less. The top surface 43 of each wafer is nearly coplanar with the main portion 35 of the wafer carrier top surface 34 surrounding each pocket. The bottom surface 45 of each wafer faces downwardly toward the floor surface 46, but is spaced above the floor surface. The gas supply apparatus 14 and gas supply element 12 are operated to supply the reaction gasses, and spindle 20 is rotated so as to rotate the wafer carrier about the axis 22 of the spindle.

As the spindle and wafer carrier rotate, heating element 20 heats the bottom surface 36 of the wafer carrier principally by radiant heat transfer, with some convection and conduction through the gas intervening between the heating element and the bottom surface of the wafer carrier. The radiant heat is symbolically shown at 56 in FIG. 3. The heat transferred to the bottom surface of the wafer carrier flows upwardly toward the top surface 34 and towards the wafers 42 disposed in the pockets 44 on the top surface. Heat is continually transferred from the top surface of the wafer carrier and from the exposed upwardly facing or top surface 43 of each wafer 42 to the surroundings, and particularly to the relatively cool gas inlet structure 12.

In the operative position shown in FIGS. 1 and 3, the bottom surface 36 of the wafer carrier directly confronts the heating element 28. As used in this disclosure, the term "directly confronts" means that there is a direct line of sight between the heating element and the bottom surface of the wafer carrier, which is unobstructed by any solid element intervening between the heating element and the wafer carrier. The bottom surface 36 of the wafer carrier desirably is disposed at a distance H above the heating element 28. This distance is greater within depressions 54; it is at a maximum Hₘₐₓ at the deepest point of each depression 54, and at a minimum Hₘᵢₙ outside of the depressions. Distance H varies oppositely to thickness t.

Unless otherwise specified, as used in this disclosure the term "vertical thermal resistance" refers to the resistance to heat flow in the upward direction per unit of area in a horizontal plane. A "horizontal" plane is a plane perpendicular to the upward direction. The vertical thermal resistance R₃₆₋₃₄ of the wafer carrier body to heat flow through the body, between bottom surface 36 and top surface 34, varies directly with the thickness t of the wafer carrier body. In theory, because the distance H is smaller where the wafer carrier is thicker, the resistance to radiant heat transfer between the heating element 28 and the bottom surface of the wafer carrier body is slightly less at those locations where the wafer carrier is thicker. In practice, this difference is negligible. Also, the resistance to convective and conductive heat transfer from the heating element 28 to the wafer carrier bottom surface via the gas in the reaction chamber may be less where the wafer carrier is thicker and H is smaller. However, convective and conductive heat transfer at all of the locations is small in comparison to radiant heat transfer. Thus, the variation in vertical thermal resistance R₂₈₋₃₆ between heating element 28 and bottom surface 36 is small in comparison to the variation in vertical thermal resistance between the bottom surface of the body and top surface of the body. The vertical thermal resistance R₂₈₋₃₄ to heat flow between the heating element 28 and a particular location on the top surface 34 of the wafer carrier varies directly with the thickness of the wafer carrier beneath that location. For example, for a location on the floor 46 of the pocket (FIG. 3) near the central axis 48 and aligned with depression 54 in the bottom surface, the thickness t of the wafer carrier body is equal to tₘᵢₙ and therefore R₂₈₋₃₄ is also small. At locations on the floor 46 near the periphery, the thickness t=tₘₐₓ and therefore R₂₈₋₃₄ is greater.

The deposition process builds up the compound semiconductor on the exposed top surface 43 of each wafer 42. Typically, the first semiconductor layers deposited are in the nature of a base or buffer layer which may be on the order of 1-10 µm thick, followed by very thin active layers which form the active layers of the device. For example, in an LED which incorporates a multiple quantum well ("MQW") structure, the light-emitting layers of the MQW structure may be on the order of 20-30 Angstroms (2-3 nm) thick. The active layers may, in turn, be followed by additional layers for purposes such as carrier confinement, electrical injection, current distribution and physical protection. During the deposition process, wafers 42 tend to bow in a relatively predictable manner. The bowing typically arises from the difference in lattice constants between the deposited semiconductor material and the wafer, and from the thermal gradient imposed across the wafer. In the example shown, the bowing makes the wafer convex in the upward direction, i.e., makes the top surface 43 of the wafer convex. The degree of bowing is greatly exaggerated in FIG. 3 for clarity of illustration. Typically, for wafers of about 50 mm diameter, such bowing D_{W} typically is on the order of about 5 µm, although greater bowing, on the order of a few tens of µm may occur in some processes with wafers of this diameter. For a given process, the bowing D_{W} tends to vary with the square of the wafer diameter. Thus, if all other factors are equal, a wafer of 6 inch nominal diameter will exhibit 9 times as much bowing as a wafer of 2 inch nominal diameter.

The temperature prevailing at the top surface 43 of each wafer depends upon the total thermal resistance between the heating element 28 (FIG. 1) and the top surface 43 of the wafer. At any point on the wafer aligned with the floor 46, the total thermal resistance is the sum of the resistance to radiant heat transfer between the heating element 28 and the bottom surface of the wafer carrier; the thermal resistance associated with conduction between the bottom surface and the floor surface 46; the resistance to heat conduction across the gap 60 between the bottom surface 45 of the wafer and the floor surface 46; and the resistance to conduction through the wafer itself. As discussed above, the resistance to radiant heat transfer between the heating element 28 and the bottom surface 36 is substantially uniform across the entire wafer carrier. In theory, because the surface of depression 54 is at a slightly greater distance from the heating element than the surrounding portions of bottom surface 36, there is a slight increase in resistance to radiant heat transfer associated with the depressions. In practice, this difference is negligible. The resistance to conduction through the wafer 42 is also substantially uniform across the entire wafer. However, the resistance to heat transfer from floor surface 46 to the bottom surface 45 of the wafer, across gap 60, varies because of the bowing in the wafer. Gap 60 typically is filled with a stagnant layer of process gas. This gas has relatively low thermal conductivity, and hence, the resistance to heat transfer across the gap provides an appreciable portion of the total resistance to heat transfer between the heating element and the wafer top surface. The thermal resistance of gap 60 is directly related to the height of the gap. For those portions of the wafer close to the periphery of the wafer, the height of the gap is simply the height of the support ledge 50 above the floor surface, i.e., D46. However, adjacent the central axis 48, the height of gap 60 is increased by the bowing distance D_{W} of the wafer. Thus, the thermal resistance of the gap is at a maximum near the central axis 48.

The varying thickness, and hence varying thermal resistance of the wafer carrier body 32 provided by depressions 54, counteracts the effect of the varying thermal resistance to gap 60. Thus, adjacent the central axis 48, the wafer carrier body has minimum thermal resistance; whereas, remote from the central axis 48, the wafer carrier body has greater thermal resistance. Stated another way, the total thermal resistance from the heating element to the top surface of the wafer is R₂₈₋₃₄ (the thermal resistance between the heating element and a point on the wafer top surface 34 within floor 46), the resistance of the gap 60 and the resistance through the wafer itself. Where the thermal resistance of gap 60 is larger, R₂₈₋₃₄ is smaller.

The difference in thickness of the wafer carrier in the regions aligned with the floor 46 of each wafer-holding region is selected to optimize the counter-balancing effect of the differing thermal conductivity in the wafer carrier at that stage of the process where the most critical layers of the device are formed. Thus, the bowing distance D_{W} progressively increases during deposition of the first layers, such as buffer layers, on the wafer top surface. The predicted bowing D_{W} used to select the difference in thickness between tₘᵢₙ and tₘₐₓ should be selected to correspond to the value of D_{W} prevailing after deposition of the buffer layers, and during deposition of the most critical layers in the device to be fabricated.

The thermal conductivity of the solid material in wafer carrier 32 is many times greater than the thermal conductivity of the stagnant gas in gap 60. Therefore, the difference in thickness (tₘₐₓ-tₘᵢₙ) required to counteract the effect of a given bowing D_{W} is many times D_{W}. For example, to counteract expected bowing of about 5-7 µm, the difference in thickness (tₘₐₓ-tₘᵢₙ) desirably is about 3 to about 6 mm. The exact difference (tₘₐₓ-tₘᵢₙ) required for a given application can be derived by heat transfer calculations. More preferably, however, the optimum value of (tₘₐₓ-tₘᵢₙ) and hence the optimum depth for depressions 54 can be determined by actual testing using a test wafer carrier having depressions of different depth and observing the effects of these on uniformity of the deposition. For example, in one process for forming of GaN-based LEDs, wafers processed on a first carrier without any depressions 54 show a "bullseye" pattern. LED's formed from the center of the wafer have a relatively long emission wavelength, whereas LED's formed from the periphery of the wafer have a relatively short emission wavelength, indicating that the wafer top surface 43 in the center was appreciably cooler than the wafer top surface at the periphery of the wafer during deposition of the layers which control the emission wavelength. The distribution of emission wavelengths is relatively broad, with more than 5% of the wafers having emission wavelengths more than 3nm from the mean emission wavelength. A second wafer carrier having relatively deep conical depressions 54 yields a reversed bullseye pattern, with LEDs from the center of each wafer having substantially shorter emission wavelengths than LEDs from the periphery, and with a similarly broad wavelength distribution. This indicates that the depressions 54 are overcompensating for the bowing. A third carrier with conical depressions about of lesser depth yields a narrower wavelength distribution than either the first or the second carrier. Thus, depressions as used in the second carrier, are used for further carriers in production operations.

Providing differing thermal conductance by varying the thickness of the solid material having relatively high thermal conductivity provides a fundamental advantage, in that minor deviations from the ideal difference in thickness (tₘₐₓ-tₘᵢₙ) have only trivial effects on the heat transfer. For example, the tolerance on the depth of recess 54 can be on the order of about ± 10 µm (± 0.0005 inches), which provides a practical machining tolerance. It would be possible to achieve the same compensation for bowing of the wafer by making floor surface 46 convex in an amount equal to the expected value of D_{W}. However, such an arrangement would require tolerances considerably less than 1 µm, and would require a complex machining process to form the floor surface in a deliberately convex shape.

A wafer carrier 132 in accordance with a further embodiment of the invention (FIG. 4) has pockets 144 with a floor surface 146 and a support ledge 150 similar to the features discussed above with respect to FIGS. 1-3. The bottom surface 140 of the wafer carrier according to this embodiment has nonplanarities in the form of depressions 154 aligned with the central axis 148 of each floor surface. These features operate in substantially the same manner as discussed above with respect to FIGS. 1-3. Additionally, the wafer carrier 132 of FIG. 4 has further nonplanarity in the form of projections or increased thickness areas 170 aligned with the support ledge 146 of each wafer-holding area. Thus, each area of increased thickness 170 is in the form of a loop concentric with the central axis 148 of the floor surface, and hence, concentric with the support ledge 150. In operation, the periphery of the wafer 142 within each pocket 144 rests on the support ledge 150. This provides a more direct path for heat transfer to the periphery of the wafer. Stated another way, the direct contact between the support ledge 150 and the periphery of the wafer provides thermal resistance less than that provided by heat transfer through the gap 160 between the floor surface 146 and the bottom surface of the wafer. The increased thickness provided by the projection 170 increases the thermal resistance of the wafer carrier body 132 in the areas aligned with the support ledge, and thus counteracts this difference. This helps to minimize differences in surface temperature between the periphery of the wafer and the adjacent areas.

Additionally, the bottom surface of wafer carrier 132 has further projections 172 aligned with those regions 134a of the carrier top surface between pockets 144. This provides still higher thermal resistance in these areas of the wafer carrier. The interface between the wafer carrier and the wafer 142 introduces appreciable thermal resistance. This tends to reduce the temperature of wafer top surface 143 below the temperature of the surrounding areas defined by the main portion 135 of the wafer carrier top surface 134. It is desirable to minimize differences between these temperatures. The increased thermal resistivity provided by projections 172 counteracts the effect of the additional interfaces, and thus maintains the temperatures of the main portion 135 close to the temperature of the wafer top surface 143. In this regard, the emissivity of the main portion 135 of the wafer carrier typically will differ from the emissivity of the wafer top surfaces 143. The difference in emissivity will influence the temperature difference between the main portion 135 and the wafer top surfaces. Where the emissivity of the main portion is significantly higher than the emissivity of the wafer, the main portion may tend to run at a lower temperature than the wafer top surfaces. In this case, the wafer carrier may have depressions, rather than projections, in those portions of the bottom surface aligned with the main portion of the top surface. In this case (not shown) the portions of the wafer carrier aligned with the main portion of the wafer carrier top surface will be thinner, and have lower thermal resistance, than the portions of the wafer carrier aligned with the pockets and wafers.

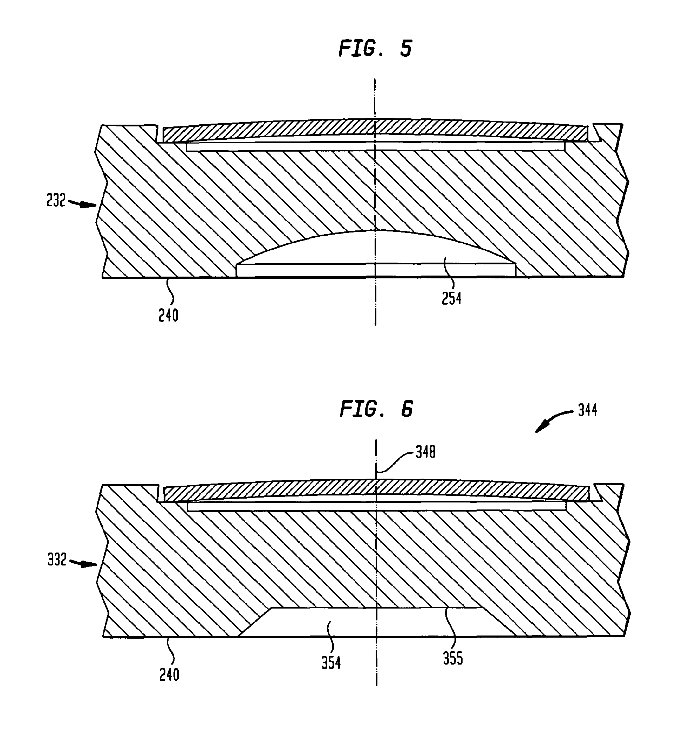

The wafer carrier 232 depicted in FIG. 5 is similar to the wafer carrier 32 of FIGS. 1-3. However, the depressions 254 in the bottom surface 240 have a generally dome-like shape rather than the conical shape discussed above.

In the wafer carrier'332 of FIG. 6, each depression 354 is in the shape of a frustum of a cone and has a flat surface 355 extending across the central axis 348 of the pocket 344.

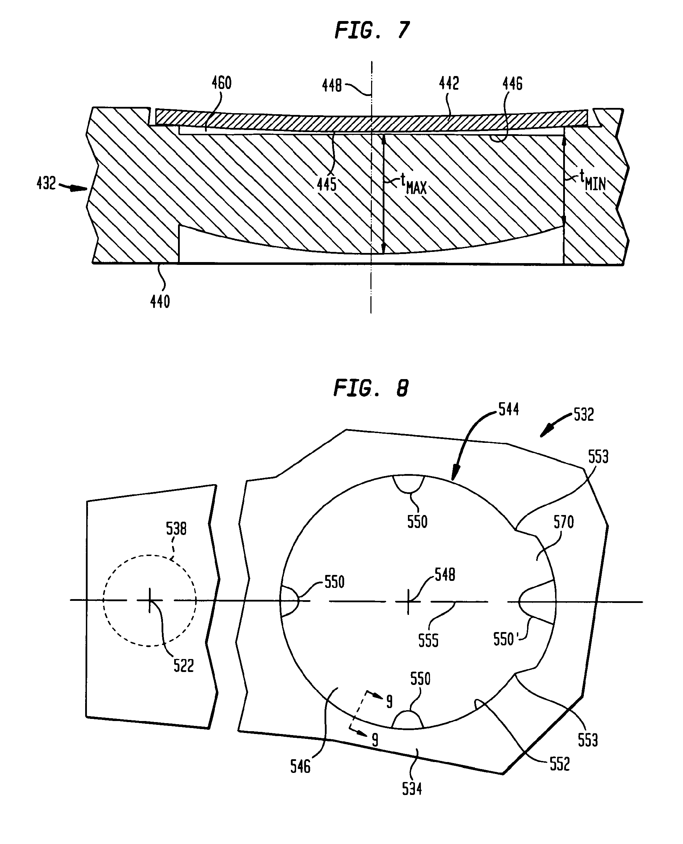

The wafer carrier 432 of FIG. 7 is arranged for use in processes where the bowing is in reverse of that discussed above, and hence, makes the wafer 442 convex downwardly, i.e., such that the bottom surface 445 of the wafer curves downwardly toward the floor surface 446 adjacent the central axis 448 of the pocket. In this situation, the gap 460 between the carrier and the wafer has minimum thickness and hence minimum thermal resistivity adjacent the central axis 448. Thus, the nonplanarities in the wafer carrier bottom surface 440 are arranged to provide a relatively large thickness tₘₐₓ adjacent the central axis, and a relatively small thickness tₘᵢₙ near the periphery of the wafer.

A wafer carrier 532 according to a further embodiment of the invention has a pocket 544 formed in the top surface 532 of the carrier within each wafer-holding area in substantially the same way as discussed above. Each pocket 544 has a flat floor surface 546. Here again, each pocket is provided with a support ledge to engage the periphery of a wafer and hold the wafer above the floor surface 546. However, in this embodiment, the support ledge for each pocket is provided as a plurality of ledge regions 550 spaced apart from one another around the periphery of the floor, and hence around the central axis 548 of the pocket. This minimizes contact between the periphery of the wafer and the support ledge, and hence minimizes inequality in heat transfer between the wafer carrier and the wafer resulting from such contact.

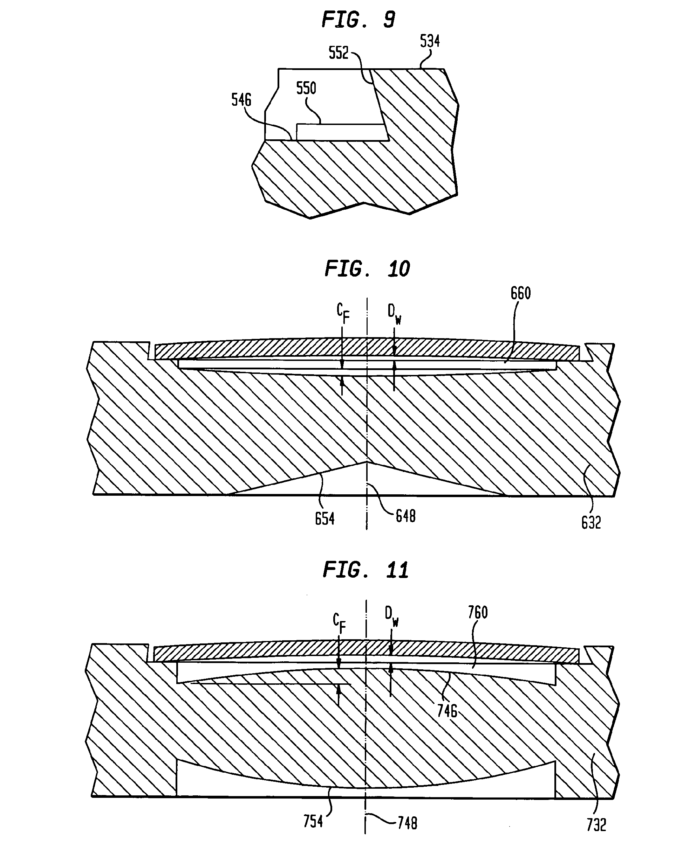

In this embodiment as well, each pocket is bounded by a wall 552 extending upwardly from the interior of the pocket to the top surface 534 of the wafer carrier. Here again, the peripheral wall 552 is inclined inwardly as shown in FIG. 9, so that the peripheral surface slopes inwardly toward the central axis 548 of the pocket in the upward direction toward the top surface 534 of the wafer carrier. In this embodiment, however, the peripheral wall 552 is interrupted by a recess 570 along a portion of the pocket furthest from the central axis 522 of the wafer carrier, i.e., furthest from the fitting 538 which holds the wafer carrier on the spindle and furthest from the axis of rotation of the wafer carrier as a whole. Thus, the peripheral wall and recess defines a non-circular shape as seen from above, as in FIG. 8. The non-circular shape includes a pair of projections 553 at the intersection of the circular peripheral wall and recess. These projections are spaced apart from one another and disposed on opposite sides of a radial line 555 extending from the central axis 522 of the wafer carrier through the central axis 548. of the pocket. During operation, the acceleration due to rotation or "centrifugal force" acting on the wafer will tend to force the wafer toward the peripheral wall in the regions furthest from the central axis 522. The recess 570 tends to maximize the force of contact between the periphery of the wafer and the inwardly sloping peripheral wall and thus maximizes the downward forces exerted on the wafer, tending to hold the wafer in engagement with the support ledge 550. A circular wafer disposed in the pocket will engage the wafer carrier at the projections 553, and remain slightly spaced from the peripheral wall at other locations. Because the wafer engages the peripheral wall only at the projections, heat transfer through the edge of the wafer will be minimized. This tends to minimize temperature variations within the wafer.

A wafer carrier having the pocket configuration discussed above with reference to FIGS. 8 and 9 may be made with or without non-planar features on its bottom surface as discussed herein.

In the wafer carriers discussed above with reference to FIGS. 1-7, the floor surfaces are substantially flat. However, this is not essential as the invention can be practiced using curved floor surfaces. For example, a wafer carrier body 732 depicted in FIG. 10 is generally similar to the wafer carrier body 32 discussed above with reference to FIGS. 1-3. However, the carrier body 632 has floor surfaces 646 which are deliberately made concave. The central portion of each floor surface at the central axis 648 of the pocket is depressed by a distance C_{f} below the peripheral portion of the floor surface, remote from axis 648. The concave floor surface makes the gap 660 between the wafer and the floor surface larger at the central axis 648 than at the periphery of the wafer. This increases the thermal resistance of the gap 660 near axis 648, in the same manner as the upward bowing D_{W} of the wafer. Stated another way, the effects of the floor surface curvature C_{f} and the upward bowing D_{W} are additive. The combined effects of floor surface curvature and bowing of the wafer are counteracted by a nonplanarity in the form of a depression 654. Depression 654 provides the carrier body with minimum thickness and hence minimum thermal resistance near the central axis 648, where the gap 660 has maximum thermal resistance.

In the embodiment of FIG. 11, the floor surface 746 is convex. Thus, the curvature C_{f} of the floor surface reduces the size of the gap 760 near the central axis 748 of the pocket. In the embodiment depicted, the wafer has upward bowing, which tends to increase the size of gap 760 near the central axis 748. However, the convex curvature C_{f} is greater than the bowing D_{W}, so that the size of gap 760 is at a minimum near the central axis 748, and the thermal resistance of the gap is also at a minimum near the central axis. To counteract the combined effects of bowing and floor surface curvature, the wafer carrier body has nonplanarities 754 arranged so that the thickness and hence thermal resistance of the body is greater near axis 748 than remote from the axis.

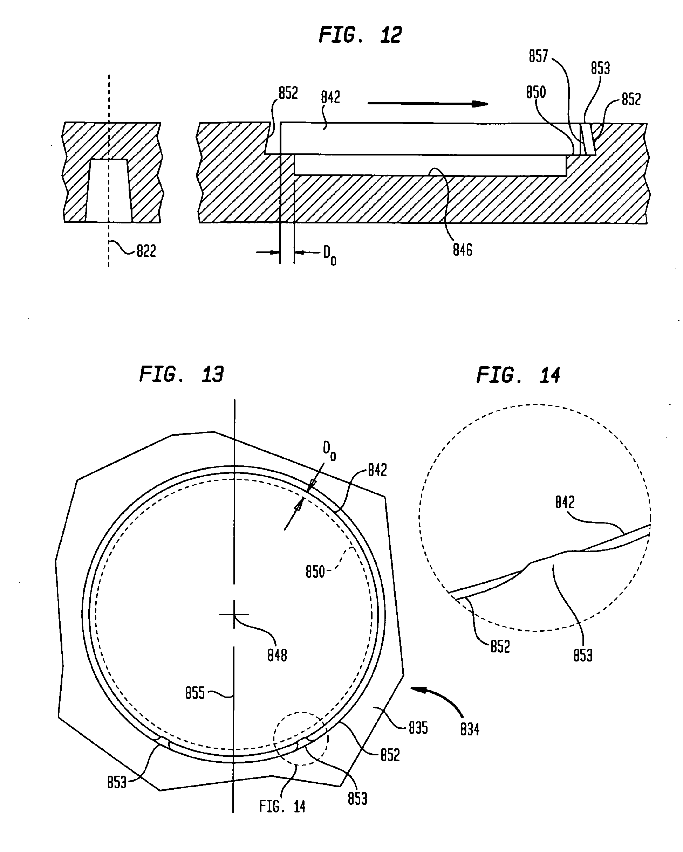

A wafer carrier shown in FIGS. 12-14 has a top surface 834 including a main portion 835 and pockets 844 similar to those discussed above with reference to FIGS. 1-3. Here again, each pocket includes a floor 846, support ledged 850 and a peripheral wall 852 projecting upwardly from the support ledge to the main portion 835 of the top surface. Here again, the wafer carrier has a central axis 822 and the wafer carrier is adapted for mounting to a spindle so that the wafer carrier will rotate about such axis during operation. Each pocket also has a central axis 848 at the geometric center of the pocket. The peripheral wall 852 includes an arcuate portion extending almost entirely around the pocket central axis 848. However, the region of the peripheral wall furthest from the central axis 822 of the wafer carrier has a non-circular shape. This region of the peripheral wall has a pair of projections 853 projecting inwardly from the arcuate portion of the peripheral wall. One such projection is shown in detail in FIG. 14. Projections 853 are spaced apart from one another on opposite sides of a radial line 855 extending from the wafer carrier central axis through the central axis 848 of the pocket. As best seen in FIG. 12, each projection 853 has an abutment surface 857 facing inwardly, toward the pocket central axis 848. Each abutment surface 857 slopes inwardly, toward the pocket central axis, in the upward direction from ledge 850 to main portion 835.

In operation, circular wafers 842 are disposed in the pockets and with the bottom surfaces of each wafer in engagement with the ledge 850 of the corresponding pocket. The centrifugal force arising from rotation of the wafer carrier about central axis 822 tends to force each wafer outwardly away from the central axis. Each wafer will rest against the abutment surfaces 857 of the two projections 853 in the pocket. The projections are dimensioned so that when the edge of a wafer rests against the projections, the wafer is concentric with the axis 848 of the pocket. Thus, the wafer overlaps the ledge 850 equally around the entire periphery of the wafer. Stated another way, the overlap distance Dₒ (FIGS. 12 and 13) between the inner edge of ledge 850 and the edge of the wafer is constant. This tends to equalize heat transfer between the bottom of the wafer and the ledge around the periphery of the wafer. Moreover, because the edge of the wafer contacts only the small, spaced-apart projections 853, heat transfer between the edge of the wafer and the peripheral wall 852 is minimized.

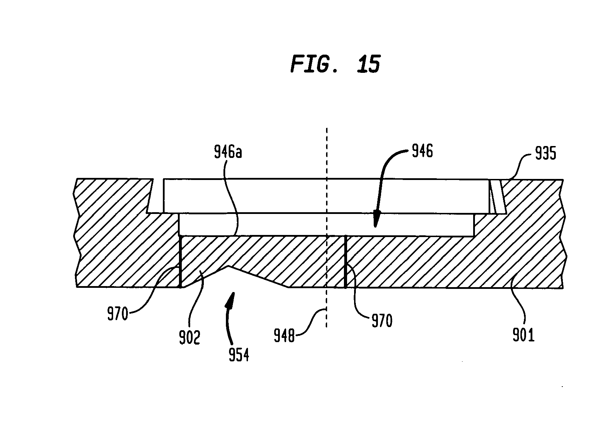

A wafer carrier according to yet another embodiment of the invention (FIG. 15) has a configuration generally similar to the wafer carrier discussed above with reference to FIGS. 1-3. However, in the wafer carrier of FIG. 15, each depression 954 in the bottom surface is offset in a horizontal direction from the center 948 of the pocket. Thus, the thinnest portion of the wafer carrier, with the highest heat conductance and lowest thermal resistance, underlies a portion 946a of the pocket floor 946 offset from the center of the floor. This configuration can be used to counteract the effects of unequal heat transfer from the wafer caused by process conditions such as process gas flow patterns. For example, in a reactor with a rotating wafer carrier, the portion of each wafer closest to the axis of rotation of the wafer carrier may be cooled to a greater degree than the portion furthest from the axis of rotation as the process gasses flow over the wafers with a component of motion in the away from the axis of rotation. Also, the process gasses flowing across different wafers or different portions of the same wafer may be at different temperatures. For example, where the main surface of the wafer carrier is cooler than the surfaces of the wafer, the temperature of the process gas will depend on the path which the gas takes before reaching a wafer at the periphery of the wafer carrier. If a large part of the path extends over wafer surfaces and only a small portion of path extends over the wafer carrier main surface, the gas will be at one temperature. If a large part of the path extends over the wafer carrier main surface, the gas will be at a lower temperature. The techniques discussed herein can be used to compensate for these effects and maintain the top surfaces of the various wafers at uniform temperatures. In a further variant, these techniques can be applied to deliberately create non-uniform wafer surface temperatures. Such non-uniform temperatures can be used, for example, to counteract the effects of non-uniform reactant concentrations in the process gasses flowing along different paths.

The wafer carrier of FIG. 15 also includes thermal barriers 970. The thermal barriers inhibit heat conduction within the body of the wafer carrier in horizontal directions. Such barriers provide thermal isolation between portions of the wafer carrier having different thermal conductance in the vertical direction. Such isolation reinforces the effect of different thermal conductance. The thermal barriers may include thin, vertically-extending layers of material having lower thermal conductivity than the surrounding material of the wafer carrier. Alternatively, the thermal barriers may be formed by fabricating the wafer carrier as separate pieces and providing interfaces between the pieces at surfaces which extend vertically within the wafer carrier. For example, the carrier of FIG. 15 includes a major portion 901 defining the main portion of the top surface and part of pocket floor 946, as well as a minor portion 902 defining part 946 of the floor of each pocket. The interface or barrier 970 may be in the form of a cylindrical surface surrounding the minor portion. In a further variant, the minor portion may define the entire floor of each pocket.

Numerous variations and combinations of the features discussed above can be utilized without departing from the present invention. Merely by way of example, although the invention has been described with reference to processing of gallium nitride-based semiconductors, the invention can be applied to processing of essentially any semiconductor. Thus, III-V semiconductors containing one or more of gallium, indium, and aluminum in combination with one or more of nitrogen, phosphorous, antimony and arsenic can be formed. Also, II-VI semiconductors and group IV semiconductors such as silicon and diamond-like carbon can be processed in similar ways. Further, the invention can be applied in processing operations other than deposition.

Numerous other variations and combinations of the features discussed above can be utilized. For example, instead of varying the thickness of the wafer carrier body, the composition of the body can vary within the area occupied by each wafer so as to provide differing thermal resistance. Merely by way of example, a wafer carrier may have depressions in its bottom surface which are filled with a metal or other material having substantially higher or lower thermal conductivity than the surrounding material of the carrier body. However, such an embodiment can have additional thermal resistance at the interfaces between materials, and such interfaces will influence the thermal resistance.

The embodiment discussed above with reference to FIG. 1 is a "susceptorless" treatment apparatus, in which heat is transferred from the heating element 28 directly to the bottom surface 36 of the carrier. Similar principles can be applied in apparatus where the heat is transferred from the heating element to an intermediate element, commonly referred to as a "susceptor," and transferred from the susceptor to the carrier. However, such heat transfer desirably does not include transfer through a space filled with stagnant process gas between the susceptor and the bottom surface of the wafer carrier.

Although the invention herein has been described with reference to particular embodiments, it is to be understood that these embodiments are merely illustrative of the principles and applications of the present invention. It is therefore to be understood that numerous modifications may be made to the illustrative embodiments and that other arrangements may be devised without departing from the spirit and scope of the present invention as defined by the appended claims.
The following numbered clauses set out specific embodiments that may be useful in understanding the present invention:

### CLAUSES

1. A chemical vapor deposition apparatus comprising:
   (a) a reaction chamber;
   (b) a gas inlet structure communicating with the reaction chamber;
   (c) a heating element mounted within the reaction chamber; and
   (d) a wafer carrier comprising a body having oppositely-facing top and bottom surfaces, the wafer carrier being mounted in the reaction chamber so that heat evolved in the heating element will be transferred from the heating element to the bottom surface of the body principally by radiation, the body having a plurality of wafer-holding regions, the body defining a wafer support in each wafer-holding region, each such wafer support being adapted to hold a wafer with a top surface of the wafer exposed at the top surface of the body, the bottom surface of the body being non-planar so that the body varies in thickness, an aggregate thermal resistance between the heating element and an arbitrary location on the top surface of the wafer carrier varying directly with the thickness of the body at that location.
2. Apparatus as claimed in clause 1 wherein the body of the wafer carrier is disposed above the heating element with the bottom surface of the body directly confronting the heating element,
3. Apparatus as claimed in clause 1 wherein the gas inlet structure is disposed above the wafer carrier and arranged to direct gas downwardly towards the wafer carrier.
4. Apparatus as claimed in clause 3 further comprising a spindle mounted in the reaction chamber for rotation about a vertical axis, the wafer carrier being mounted the spindle for rotation therewith.
5. Apparatus as recited in clause 1 wherein each wafer support is arranged to engage a peripheral portion of a wafer and to hold the wafer so that a main portion of the wafer is spaced from the body of the carrier.
6. Apparatus as recited in clause 1 wherein each wafer support includes a floor and a support ledge disposed above the floor at the periphery of the floor.
7. Apparatus as recited in clause 6 wherein the nonplanarities in the bottom surface are arranged so that within each wafer-holding region the body has a non-uniform thickness within a region aligned with the floor.
8. Apparatus as recited in clause 7 wherein within each wafer-holding region, the thickness of the body is at a local minimum at a location aligned with the center of the floor.
9. Apparatus as recited in clause 7 wherein within each wafer-holding region, the thickness of the body is at a local minimum at a location offset from the center of the floor.
10. Apparatus as recited in clause 7 wherein within each wafer-holding region, the thickness of the body is at a local maximum at a location aligned with the center of the floor.
11. Apparatus as recited in clause 7 wherein each said floor is substantially planar.
12. Apparatus as recited in clause 6 wherein the top surface of the body includes a main portion extending between the wafer-holding regions and each wafer support includes a pocket, the floor and support ledge of each wafer support being recessed from the main portion of the top surface within the pocket so that the floor forms a bottom surface of the pocket.
13. Apparatus as recited in clause 12 wherein the thickness of the body beneath at least a part of the main portion of the top surface is greater than the thickness of the body beneath the floors of the wafer supports.
14. Apparatus as recited in any one of clauses 6-13 wherein each support ledge is substantially continuous and encircles the floor.
15. Apparatus as recited in any one of clauses 6-13 wherein each support ledge includes a plurality of ledge regions spaced apart from one another around the periphery of the floor.
16. Apparatus as recited in any one of clauses 6-13 wherein, within each wafer-holding region, the body has a greater thickness in a region aligned with the support ledge than in an immediately adjacent region aligned with the floor.
17. Apparatus as recited in any one of clauses 1-13 in which the body consists of a substantially monolithic slab of a refractory material with or without a coating on the slab.
18. A method of processing wafers comprising the steps of:
   (a) mounting one or more wafers on a wafer carrier so that each wafer is disposed within a wafer-holding region of the carrier and exposed at a top surface of the carrier, the carrier having varying thermal conductance within each wafer-holding region;
   (b) heating a bottom surface of the wafer carrier so that heat transmitted through the wafer carrier maintains the wafers at an elevated temperature;
   (c) while the wafers are at the elevated temperature, applying reactive gasses to affect the exposed surfaces of the wafers;
   wherein the wafers are bowed during the step of applying reactive gasses and the bowing causes nonuniformity in heat transfer from the wafer carrier within each wafer, the varying thermal conductance of the wafer carrier at least partially compensating for the nonuniformity in heat transfer caused by the bowing.
19. A method as recited in clause 18 wherein the step of applying reactive gasses includes applying the reactive gasses to form a deposit on an exposed surface of each wafer.
20. A method as recited in clause 18 or clause 19 wherein the step of mounting the wafers is performed so as to position each wafer on or above a substantially flat, upwardly-facing floor surface of the wafer carrier.
21. A method as recited in clause 20 wherein the step of mounting the wafers is performed so as to position each wafer above the floor surface.
22. A method as recited in clause 18 wherein a bottom surface of the wafer carrier has one or more nonplanarities in the bottom surface within each wafer-holding region so that the thickness of the wafer carrier varies within each wafer-holding region, and wherein the step of heating the bottom surface includes operating a heating element while maintaining the heating element directly confronting the bottom surface of the wafer carrier.
23. A method as recited in clause 22 further comprising the step of moving the wafer carrier during the heating and applying steps.
24. A method as recited in clause 18 wherein the step of mounting each wafer on the wafer carrier includes engaging a peripheral region of the wafer with a support ledge on the wafer carrier so that the support ledge holds a main portion of the wafer elevated above a floor surface of the carrier.
25. A method as recited in clause 24 wherein in each wafer-holding region the wafer carrier has a nonplanarity in its bottom surface such that the wafer carrier has greater thickness and lesser thermal conductivity in a region aligned with the support ledge than in an immediately adjacent region aligned with the floor surface.
26. A method as recited in clause 25 wherein the step of mounting each wafer on the wafer carrier includes engaging the peripheral portion of the wafer with spaced-apart elements of the wafer carrier cooperatively constituting the support ledge.
27. A wafer carrier comprising a body having oppositely-facing top and bottom surfaces extending in horizontal directions, the body having a plurality of wafer-holding regions, the body defining a wafer support in each wafer-holding region, each such wafer support being adapted to hold a wafer with a top surface of the wafer exposed at the top surface of the body, the body having one or more thermal barriers inhibiting conduction of heat in horizontal directions.
28. A wafer carrier as claimed in clause 27 wherein the wafer carrier has regions of different thermal conductance in the vertical direction and the thermal barriers are disposed between the regions of different conductance.
29. A wafer carrier comprising a body having oppositely-facing top and bottom surfaces and a central axis extending between the top and bottom surfaces, the top surface of the body having a plurality of pockets, each such pocket having a peripheral wall, the peripheral wall of each pocket having a plurality of spaced-apart projections in a region of the peripheral wall remote from the central axis of the wafer carrier, the projections being adapted to engage spaced-apart portions of an edge of a wafer disposed in the pocket.
30. A wafer carrier as claimed in clause 29 wherein each pocket has a central axis and the projections of the peripheral wall of each pocket include two projections spaced apart from one another and disposed on opposite sides of a radial line extending from the central axis of the wafer carrier through the central axis of the pocket.

## Claims

1. A wafer carrier comprising a body having oppositely- facing top and bottom surfaces, the wafer carrier capable of being mounted in a reaction chamber so that heat evolved by a heating element mounted within the reaction chamber will be transferred from the heating element to the bottom surface of the body principally by radiation, the body having a plurality of wafer-holding regions, the body defining a wafer support in each wafer- holding region, each such wafer support being adapted to hold a wafer with a top surface of the wafer exposed at the top surface of the body, the bottom surface of the body being non- planar so that the body varies in thickness, an aggregate thermal resistance between the heating element and an arbitrary location on the top surface of the wafer carrier varying directly with the thickness of the body at that location.

2. Wafer carrier as recited in claim 1 wherein each wafer support is arranged to engage a peripheral portion of a wafer and to hold the wafer so that a main portion of the wafer is spaced from the body of the carrier.

3. Wafer carrier as recited in claim 1 wherein each wafer support includes a floor and a support ledge disposed above the floor at the periphery of the floor.

4. Wafer carrier as recited in claim 3 wherein the nonplanarities in the bottom surface are arranged so that within each wafer-holding region the body has a non-uniform thickness within a region aligned with the floor.

5. Wafer carrier as recited in claim 4 wherein within each wafer-holding region, the thickness of the body is at a local minimum at a location aligned with the center of the floor.

6. Wafer carrier as recited in claim 4 wherein within each wafer-holding region, the thickness of the body is at a local minimum at a location offset from the center of the floor.

7. Wafer carrier as recited in claim 4 wherein within each wafer-holding region, the thickness of the body is at a local maximum at a location aligned with the center of the floor.

8. Wafer carrier as recited in claim 4 wherein each said floor is substantially planar.

9. Wafer carrier as recited in claim 3 wherein the top surface of the body includes a main portion extending between the wafer-holding regions and each wafer support includes a pocket, the floor and support ledge of each wafer support being recessed from the main portion of the top surface within the pocket so that the floor forms a bottom surface of the pocket.

10. Wafer carrier as recited in claim 9 wherein the thickness of the body beneath at least a part of the main portion of the top surface is greater than the thickness of the body beneath the floors of the wafer supports.

11. Wafer carrier as recited in any one of claims 3-10 wherein each support ledge is substantially continuous and encircles the floor.

12. Wafer carrier as recited in any one of claims 3-10 wherein each support ledge includes a plurality of ledge regions spaced apart from one another around the periphery of the floor.

13. Wafer carrier as recited in any one of claims 3-10 wherein, within each wafer-holding region, the body has a greater thickness in a region aligned with the support ledge than in an immediately adjacent region aligned with the floor.

14. Wafer carrier as recited in any one of claims 1-10 in which the body consists of a substantially monolithic slab of a refractory material with or without a coating on the slab.
